Europäisches Patentamt

European Patent Office

Office européen des brevets

(11) Publication number: **0 069 529 B1**

(12) **EUROPEAN PATENT SPECIFICATION**

(45) Date of publication of patent specification: **18.03.87**

(51) Int. Cl.⁴: **G 01 B 11/27, G 03 B 41/00**

(21) Application number: **82303411.1**

(22) Date of filing: **29.06.82**

(54) **Chip alignment method.**

(30) Priority: **29.06.81 JP 101115/81**

(43) Date of publication of application:
**12.01.83 Bulletin 83/02**

(45) Publication of the grant of the patent:
**18.03.87 Bulletin 87/12**

(84) Designated Contracting States:
**DE FR GB**

(56) References cited:
**EP-A-0 005 462
WO-A-80/01722
FR-A-2 435 081
US-A-4 153 367**

**MICROELECTRONICS AND RELIABILITY, vol.
15, no. 6, 1976, pages 613-618, Pergamon
Press, Oxford, G.B. , Z.M. WOJCIK: "The
alignment of graphic images in solid-state
technology"**

(73) Proprietor: **FUJITSU LIMITED
1015, Kamikodanaka Nakahara-ku
Kawasaki-shi Kanagawa 211 (JP)**

(72) Inventor: **Iijima, Nobuo
3016-1-416, Nagatsuda-cho Midori-ku
Yokohama-shi Kanagawa 227 (JP)**
Inventor: **Ono, Yoshinobu
17-3, Chidori 2-chome
Ota-ku Tokyo 146 (JP)**
Inventor: **Watanabe, Yoshio
466-18, Eda-cho Midori-ku
Yokohama-shi Kanagawa 1227 (JP)**

(74) Representative: **Fane, Christopher Robin King
et al
HASELTINE LAKE & CO. Hazlitt House
28 Southampton Buildings Chancery Lane
London, WC2A 1AT (GB)**

(56) References cited:
**ELECTRONICS INTERNATIONAL, vol. 50, no.
10, 12th May 1977, pages 32,33, USA, "Philips
develops mask projection system with
alignment accuracy to 0.1 micrometer"**

## Description

The present invention relates to a chip alignment method, more particularly to a chip alignment method which can be suitably applied to a microprojection-type exposing apparatus.

The conventional chip alignment method used in a microprojection-type exposing apparatus is as follows. Prior to chip alignment, a pair of alignment marks provided in advance on the wafer, upon which the chip is to be formed, is read out by a microscope. The position determined by these alignment marks is used as the "origin" for positioning of the chips. These marks allow a precise relationship to be maintained between the origin and the means for exposing the wafer. The distance between the origin and the chip is known in advance. Moving the XY stage, upon which the wafer is mounted, under the control of a laser interferometer enables the chip to be positioned precisely with respect to the exposure means.

In this method, however, mechanical accuracy, XY orthogonality, heat expansion, and warp of the wafer combine to affect alignment accuracy, whereby reduced accuracy cannot be avoided. Also, since alignment accuracy is maintained independent of the operation of the exposure means, much time is required for alignment. The time required for alignment hinders the increase of the processing capacity of the exposure apparatus. To increase alignment accuracy, even, more time is required for alignment. This further impedes improvement of said processing capacity.

It has been proposed by Wojcik in "Microelectronics and Reliability", Vol. 15, 1976, pp. 613—618 to provide an alignment mark for each chip, and to position each chip for exposure by determining the position of its alignment mark electrooptically relative to an origin and computing therefrom the shift vector required to move the chip into the desired position.

In this method, the processes of alignment and exposure are independent.

To speed up processing it has been proposed in WO—A—80 01722 to move a substrate by predetermined displacements to bring successive areas thereof into a predetermined exposure position, to detect misalignment of the area being exposed by means of its alignment mark before at least a proportion of these movements, and to correct the next following displacement accordingly. Since the checking is done during the exposure, the overall time required is reduced and the process is speeded up. However, this process presupposes that the said successive areas are accurately spaced by the predetermined displacements.

The present invention aims to improve both speed and accuracy of a sequential exposure process, and thereby improve the useful processing capacity of micro-projection type exposing apparatus.

It does this by reading, during each exposure, an alignment mark of the next chip to be exposed to determine the deviation of the next chip from its ideal position, that is to say, from the position from which the next predetermined displacement would bring it into its correct exposure position, and correcting this displacement accordingly.

The positioning of each chip is thus independent of the accuracy of positioning of the previous chip. The first chip in a series may be positioned by observation of its own alignment mark.

According to the invention, a method for sequentially aligning each of a plurality of chips formed on a wafer to a predetermined exposure position by detection of alignment marks associated with the chips and thereby correcting the next predetermined displacement of the wafer, is characterised by the steps of reading, during exposure of each one chip, an alignment mark of a next chip, positioned between said one chip and said next chip, to thereby determine the deviation of said next chip from its ideal position, correcting the next predetermined displacement of the wafer according to said deviation, and moving the wafer by the corrected displacement.

The first chip in a line on the wafer may be aligned before exposure by means of its own alignment mark.

Further features and advantages of the present invention will be apparent from the ensuing description with reference to the accompanying drawings to which, however, the scope of the invention is in no way limited.

In the accompanying drawings:

Fig. 1 illustrates the construction of the apparatus to which the chip alignment method according to the present invention is used;

Fig. 2 illustrates an enlarged view of the chips shown in Fig. 1;

Fig. 3 illustrates an enlarged view of the wafer shown in Fig. 1;

Fig. 4 illustrates a detailed construction of the photo receiver shown in Fig. 1;

Figs. 5A and 5B illustrate block diagrams which show the operation of the apparatus shown in Fig. 1; and

Figs. 6A and 6B illustrate plan views of the relation between the chips and the alignment marks for the chips.

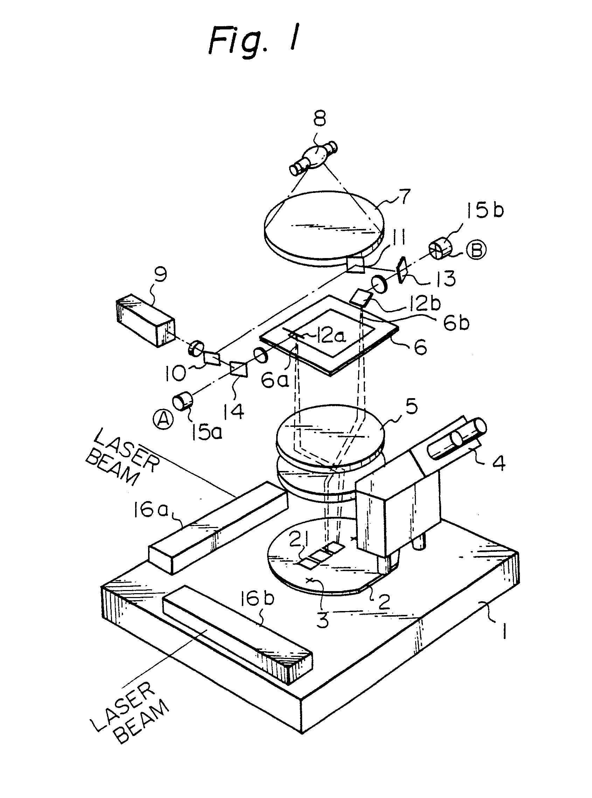

In Fig. 1, which shows the construction of the apparatus, a wafer 2 is mounted on an XY stage 1. Alignment marks 3 are placed on the wafer 2, upon which chips 21 are also formed. Reference numeral 4 denotes a wafer alignment scope, 5 a contraction lens, 6 a reticle, 7 a condenser lens, and 8 a mercury lamp, as similar to conventional apparatuses.

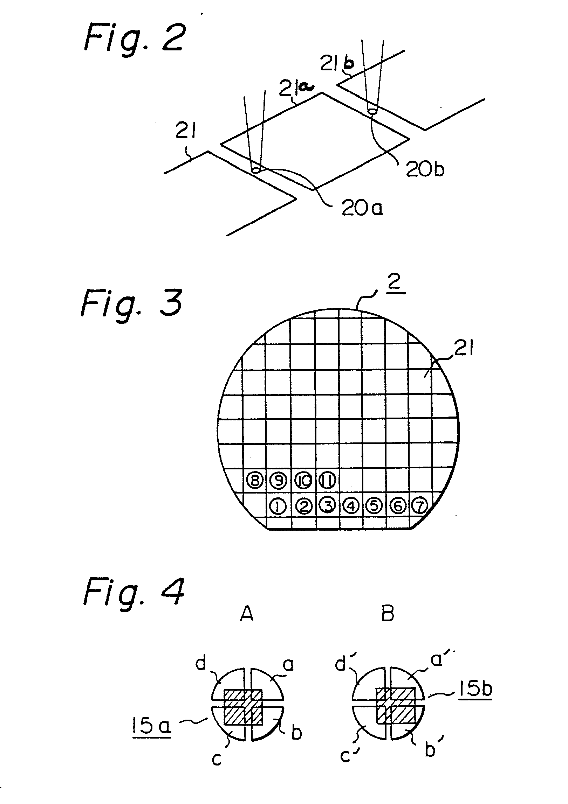

The apparatus of the present invention also includes an optical system which includes a light source 9, half-mirrors 10, 13 and 14, mirrors 11, 12a and 12b, and photo-receivers 15a and 15b. An alignment mark 20a or 20b (Fig. 2) is provided for each chip 21. Each chip is formed on wafer 2 mounted on the XY stage (Fig. 3).

According to the present invention, the alignment marks 20a, 20b are provided near each chip, for example, on a slicing line, prior to the alignment process. The number of the alignment marks is not limited.

Referring to Fig. 1, light emitted from the light source is split into two portions by half-mirror 10. The split light is projected, via through holes 6a, 6b provided on the reticle 6 and via the contraction lens 5, on to the alignment marks 20a and 20b (see also Fig. 2). The light reflected from the alignment marks 20a, 20b passes via mirrors 12a, 12b and then 14, 13, respectively, to produce images in the photo-receivers 15a, 15b as shown in Fig. 4. The photo-receivers 15a, 15b show the relation between the images of the alignment marks and photo-receiver elements a to d and a' to d'. The four element diode (SGD-444-4) produced by EG & G Co. of the U.S. can, for example, be used as the photo-receiver shown in Fig. 4.

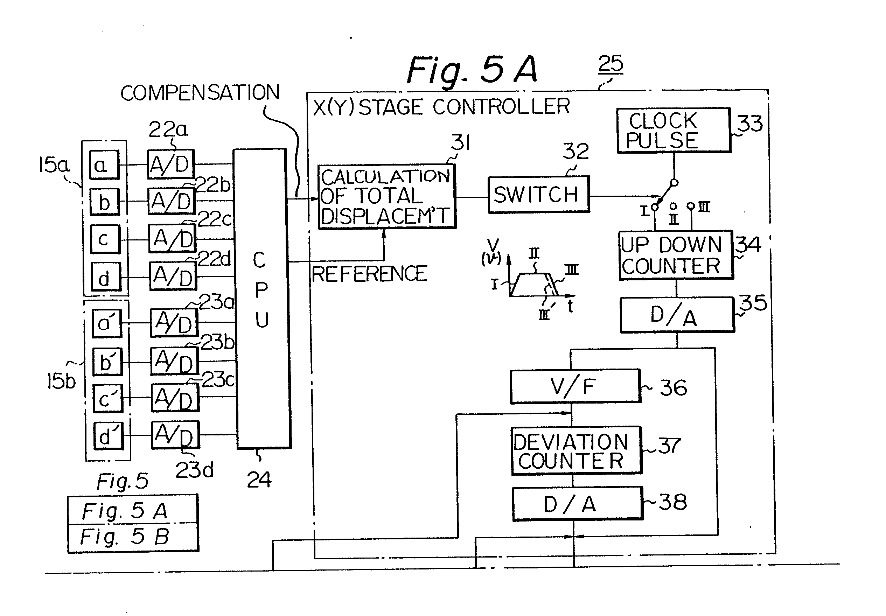

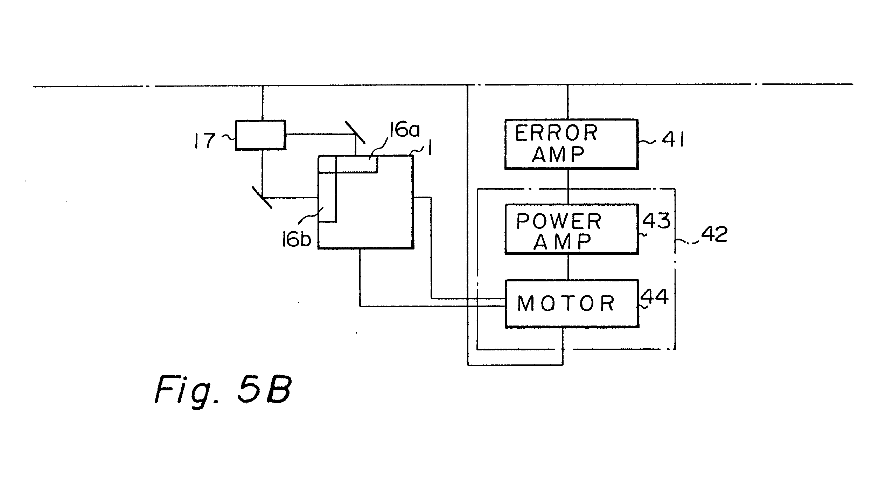

Referring to Figs. 5A and 5B, the outputs of the photo-receivers 15a and 15b are converted into digital values by the analog-to-digital (A/D) converters 22a to 22d and 23a to 23d. The converted digital values are supplied to a computer 24. In the computer 24, compensation values x and y are calculated by the following equations:

$$x=a+b+a'+b'-(C+d+c'+d')$$

$$y=a+d+a'+d'-(b+c+b'+c')$$

The calculated compensation values x, y are supplied to X(Y) stage controller 25.

X(Y) stage controller 25 is also supplied with the output of an interferometer 17 (Fig. 5B, which reads, a pair of plane mirrors 16a and 16b (Fig. 1).

The compensation values calculated in the computer 24 and the reference values stored in the computer 24 are supplied to a calculator 31. The calculator 31 calculates the total displacement values and supplies said values to a switch control circuit 32. The switch control circuit 32 distributes the output of the clock pulse generator 33 so as to form the time-velocity (voltage) curve at the output of an up-down counter 34. The time-velocity curve is formed by a velocity increasing portion I, constant velocity portion II, and a velocity decreasing portion III, III'. In Fig. 5A, the velocity decreasing portion III denotes a reference voltage curve and the velocity decreasing portion III' denotes the actually shifted voltage curve which should be compensated for. The output of the up-down counter 34 is converted to an analog value by a digital-to-analoge (D/A) converter 35. The output of the D/A converter 35 is further converted to a frequency by the voltage-to-frequency (V/F) converter 36. The output of the V/F converter 36 is compared with the output of the interferometer 17. The deviation of the frequency is calculated by the deviation counter 37. The output of the deviation counter 37 is converted to an analog value by a D/A converter 38. The output of the D/A converter 35 is compared with the output of the D/A converter 38. The positional information of the motor and the error component is applied via an error amplifier 41 and a power amplifier 43 to the motor 44.

Next, the chip alignment method according to the present invention will be explained.

The wafer 2 is mounted on the XY stage 1 and is aligned by the wafer alignment scope 4.

Next, interferometer 17 is actuated. The first chip on the wafer 2 is positioned under the exposure means. At this time, the detecting system gives positional information of the alignment mark of the first chip. This positional information is used in the X(Y) stage controller 25 to position the first chip with respect to alignment mark 20a.

After the first chip is properly positioned, the exposure means is actuated and the first chip is exposed. A relatively long time is required for this exposure. The region where this exposure is carried out includes the alignment mark 20b of the next chip to be exposed.

Therefore, while the first chip is being exposed, the detecting system reads the alignment mark 20b of the next chip to be exposed. This positional information is supplied to computer 24. Computer 24 checks for deviation relating to the positional information read from the alignment mark 20b. When no deviation exists, XY stage 1 is next displaced by a one chip unit, without compensation by the stage controller 25, in response to an output signal of interferometer 17.

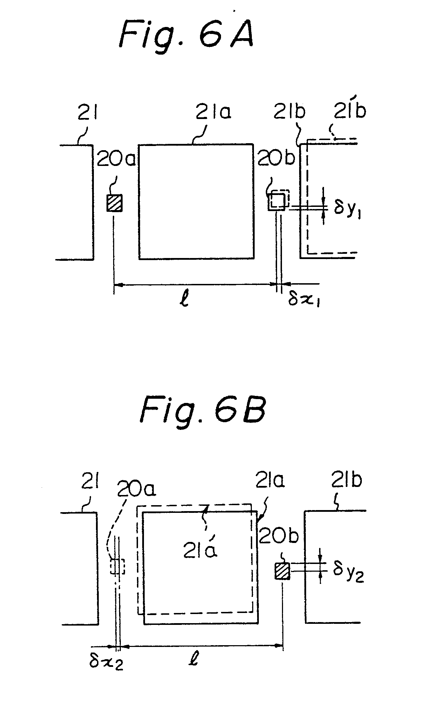

When deviation does exist, this deviation is taken into consideration as the compensation amount in stage controller 25. In such case, XY stage 1 is next displaced by a one chip unit plus or minus the compensation amount. For example, in Fig. 6A or 6B, if the alignment mark deviates as shown by the dotted line, the compensation amount is subtracted from the one chip unit displacement.

Figure 6A shows a correctly positioned chip 21a currently being exposed and an incorrectly positioned chip 21b to be exposed next, chip 21b is at the position 21'b. Therefore, the displacement amounts x, y of XY stage 1 should be:

$$x=l+dx_1$$

$$y=dy_1$$

Figure 6B shows an incorrectly positioned chip 21a currently being exposed and a correctly positioned chip 21b to be exposed next. Chip 21a is at the position 21'a. Therefore, the displacement amounts x, y of XY stage 1 should be:

$$x=l+dx_2$$

$$y=dy_2$$

Thus, the compensation amount for the next chip to be exposed is determined during exposure of the previous chip and is reflected in the displacement distance of XY stage 1 for said next chip to be exposed. Therefore, no time is necessary for chip alignment, whereby the processing capacity of the exposing apparatus can be improved.

Further, alignment compensation is carried out for every chip, so that alignment error does not accumulate. Thus, no time is necessary for improving alignment accuracy. Therefore, the processing capacity of the exposing apparatus also can be improved on this point.

The above-mentioned compensation of alignment error for each chip improves alignment accuracy.

When the exposure of the chip reaches the end of the line by carrying out the above-mentioned compensation process, the first chip of the next line should be aligned by the alignment mark provided for the first chip of the next line. The XY stage 1 is thereby displaced to move said first chip of the next line directly under the exposure means by a compensated amount, thereby allowing the above-mentioned process to be repeated for all chips on the wafer.

While the above-mentioned explanation was made for the case where the detecting system for the alignment marks is provided as part of the exposing system, it should be understood that the detecting system can be separate.

As clear from the above-mentioned explanation, in accordance with the present invention, the following effects can be obtained:

(1) No time is necessary for chip alignment at all.

(2) The processing capacity of the exposing system can be improved.

(3) Alignment accuracy can be improved.

## Claims

1. A method for sequentially aligning each of a plurality of chips (21a, 21b) formed on a wafer (2) to a predetermined exposure position by detection of an alignment mark (20a, 20b) associated with each chip (21a, 21b) and thereby correcting the next predetermined displacement of the wafer, characterised by the steps of reading, during exposure of each one chip (21a) in alignment mark (20b) of a next chip (21b), positioned between said one chip and said next chip, to thereby determine the deviation of said next chip from its ideal position, correcting the next predetermined displacement of the wafer according to said deviation, and moving the wafer by the corrected displacement.

2. A method according to claim 1 in which the first chip in a line on the wafer is aligned by detection of its own alignment mark.

3. A method according to claim 1 or claim 2 in which the detection system for the alignment marks is provided as part of the exposing system.

## Patentansprüche

1. Verfahren zum sequentiellen Ausrichten eines jeden einer Vielzahl von Chips (21a, 21b), die auf einem Wafer (2) gebildet sind, in eine vorbestimmte Exponierungsposition, durch Detektion einer Ausrichtungsmarke (20a, 20b), die jedem Chip (21a, 21b) zugeordnet ist, und dadurch Korrigieren der nächsten vorbestimmten Verschiebung des Wafers, gekennzeichnet durch die Schritte des Lesens, während jeder Exponierung eines jeden Chips (21a), einer Ausrichtungsmarke (20b) des nächsten Chips (21b), die zwischen dem genannten Chip und dem genannten nächsten Chip angeordnet ist, um dadurch die Abweichung des genannten nächsten Chips von seiner idealen Position zu bestimmen, Korrigieren der nächsten vorbestimmten Verschiebung des Wafers entsprechend der genannten Abweichung, und Bewegen des Wafers um die korrigierte Verschiebung.

2. Verfahren nach Anspruch 1, bei dem das erste Chip in einer Reihe auf dem Wafer durch Detektion seiner eigenen Ausrichtungsmarke ausgerichtet wird.

3. Verfahren nach Anspruch 1 oder 2, bei dem das Detektionssystem für die Ausrichtungsmarken als Teil des Exponierungssystems vorgesehen ist.

## Revendications

1. Procédé pour aligner séquentiellement chacune d'un ensemble de puces (21a, 21b) formées sur une tranche (2) jusqu'à une position d'exposition prédéterminée par la détection d'un repère d'alignement (20a, 20b) associé à chaque puce (21a, 21b) et pour corriger ainsi le déplacement prédéterminé suivant de la tranche, caractérisé en ce qu'il consiste à lire, pendant l'exposition de chaque puce (21a) un repère d'alignement (20b) d'une puce suivante (21b), positionné entre ladite puce et la puce suivante, pour déterminer ainsi la déviation de la puce suivante par rapport à sa position idéale, à corriger le déplacement prédéterminé suivant de la tranche selon cette déviation, et à déplacer la tranche du déplacement corrigé.

2. Procédé selon la revendication 1, dans lequel la première puce d'une ligne sur la tranche est alignée par la détection de son propre repère d'alignment.

3. Procédé selon l'une quelconque des revendications 1 et 2, dans lequel le système de détection pour les repères d'alignements est prévu comme faisant partie du système d'exposition.

# Fig. 1

LASER
BEAM

LASER
BEAM

Fig. 2

Fig. 3

Fig. 4

# Fig. 5 A

25

COMPENSATION

X(Y) STAGE CONTROLLER

CLOCK PULSE — 33

22a
15a

| a | A/D |
| b | A/D | 22b
| c | A/D | 22c
| d | A/D | 22d

CPU

CALCULATION OF TOTAL DISPLACEM'T — 31

SWITCH — 32

I  II  III

UP DOWN COUNTER — 34

REFERENCE

V (V̇)

I  II  III  t

D/A — 35

23a
15b

| a′ | A/D | 23a
| b′ | A/D | 23b
| c′ | A/D | 23c
| d′ | A/D | 23d

V/F — 36

DEVIATION COUNTER — 37

D/A — 38

24

Fig. 5

| Fig. 5 A |
| Fig. 5 B |

0 069 529

ERROR AMP ~41

POWER AMP 43

42

MOTOR 44

17~

16a

1

16b

*Fig. 5B*

# Fig. 6A

21    21a    21b    21b

20a    20b    $\delta y_1$

$\ell$    $\delta x_1$

# Fig. 6B

21    20a    21a    21b

20b    $\delta y_2$

21a

$\delta x_2$    $\ell$